# EUROPEAN PATENT SPECIFICATION

(11) **EP 2 282 328 B1**
(45) Date of publication and mention of the grant of the patent: **02.09.2015**
(21) Application number: 09754513.1
(22) Date of filing: 31.03.2009
(51) Int. Cl.: H01L 21/60, C09J 9/02, C09J 11/04, C09J 163/00, C08K 3/36, C08K 9/04

(54) **ADHESIVE FILM**
HAFTFOLIE
FILM ADHESIF

(30) Priority: 28.05.2008 JP 2008139005
(43) Date of publication of application: 09.02.2011
(73) Proprietor: Dexerials Corporation, Tokyo 141-0032 (JP)
(72) Inventor: SUGA, Yasuhiro, Kanuma-shi Tochigi 322-8502 (JP)
(74) Representative: Müller-Boré & Partner Patentanwälte PartG mbB
(86) International application number: PCT/JP2009/056592
(87) International publication number: WO 2009/145005

(56) References cited:
- EP-A1- 1 832 636
- JP-A- 11 265 910
- JP-A- 2000 080 341
- JP-A- 2004 043 602
- DATABASE WPI Week 199952 Thomson Scientific, London, GB; AN 1999-606708 XP002663146, & JP 11 265910 A (NEC CORP) 28 September 1999 (1999-09-28)
- DATABASE WPI Week 200025 Thomson Scientific, London, GB; AN 2000-286907 XP002663147, & JP 2000 080341 A (TOSHIBA CHEM CORP) 21 March 2000 (2000-03-21)

## Description

### TECHNICAL FIELD

The present invention relates to an adhesive film used when flip-chip mounting a semiconductor chip having a bump on a wiring board.

### BACKGROUND ART

When flip-chip mounting a semiconductor chip having a bump on a wiring board, anisotropic conductive films in which conductive particles are dispersed in an insulating binder composition are widely used. As such conductive particles, particles formed with an electroless plating layer on the surface of a resin core so as to squash between a connection pad of the wiring board and the bump on the semiconductor chip are used.

However, as the wiring pitch on the mounting board becomes narrower, the surface area of the bump becomes smaller. Consequently, the particle size of the conductive particles used in the anisotropic conductive film also needs to be reduced. However, it is very difficult to produce resin particles which are uniform and have a small particle size. Therefore, the wiring board and the semiconductor chip are connected and fixed (NCF bonded) by sandwiching a non-conductive adhesive film (NCF) between the wiring board and the semiconductor chip, abutting the semiconductor chip bump against the connection pad or bump of the wiring board so that the semiconductor chip bump is squashed, and curing the non-conductive adhesive film.

For NCF bonding, to improve the connection reliability of the non-conductive adhesive film, it has been proposed to add 1 to 50 parts by volume of a non-conductive filler, such as silica fine particles, having a particle size of 0.005 to 0.1 µm with respect to 100 parts by volume of resin solid content to the non-conductive adhesive film to adjust the storage modulus, linear expansion coefficient, melt viscosity and the like of the non-conductive adhesive film (see Patent Document 1, paragraphs 0043 and 0044).
[Patent Document 1] Japanese Patent Application Laid-Open No. 2002-275444

### DISCLOSURE OF THE INVENTION

### PROBLEMS TO BE SOLVED BY THE INVENTION

However, when flip-chip mounting a semiconductor chip having a bump on a wiring board by using a non-conductive adhesive film added with a filler such as silica fine particles, in some cases the silica fine particles and the binder composition are not sufficiently removed from between the connection pad or bump of the wiring board and the bump of the semiconductor chip. In such a case, the problem arises that continuity cannot be achieved between the wiring board and the semiconductor chip.

It is an object of the present invention to ensure reliable continuity when flip-chip mounting a semiconductor chip having a bump on a wiring board by NCF bonding using an insulating adhesive film added with a filler such as silica fine particles, even if the non-conductive filler and the insulating binder composition are not sufficiently removed from between a connection pad or bump of the wiring board and a bump of the semiconductor chip.

### MEANS FOR SOLVING THE PROBLEMS

To improve a non-conductive adhesive film for NCF bonding, the present inventor has found that the above-described object could be achieved by, in addition to specifying the amount of a filler to be added to the binder composition, using a filler having a much larger particle size than a conventionally used filler (i.e., 0.005 to 0.1 µm) in a specific ratio. Furthermore, the present inventor has found that the filler used in the present invention is formed as conductive particles having a much smaller particle size (1.5 µm or less) than the conductive particles for anisotropic conductive connection using a conventional resin core (approximately 5 µm) by subjecting a part of the filler to an electroless plating treatment, thereby completing the present invention.

More specifically, the present invention provides an adhesive film comprising a binder composition including an epoxy compound, a curing agent, and a filler, for flip-chip mounting a semiconductor chip having a bump on a wiring board, wherein
an amount of the filler is 10 to 70 mass% with respect to a total amount of the epoxy compound, the curing agent, and the filler,
the filler includes a first non-conductive inorganic particle having an average particle size of 0.5 to 1.0 µm, and a conductive particle formed by subjecting a second non-conductive inorganic particle having an average particle size of 0.5 to 1.0 µm to an electroless plating treatment so that the average particle size of the conductive particle does not exceed 1.5 µm, and
the conductive particle is contained in an amount of 10 to 60 mass% of the filler.

Furthermore, the present invention provides a connected structure in which a semiconductor chip having a bump is connected and fixed to a wiring board via the above-described adhesive film.

### EFFECTS OF THE INVENTION

The adhesive film of the present invention specifies the amount of filler to be added to the binder composition, and uses non-conductive inorganic particles and conductive particles having a specific particle size in a specific ratio as the filler. Therefore, the present adhesive film can ensure reliable continuity due to these conductive particles, even if the filler and the binder resin are not sufficiently removed from between the connection pad or bump of the wiring board and the semiconductor chip bump.

### BRIEF DESCRIPTION OF THE DRAWINGS

Fig. 1 is a graph illustrating the measurement results of the relative permittivity of the adhesive film of Example 1 and the anisotropic conductive film of Comparative Example 4.
Fig. 2 is a graph illustrating the relationship between the occurrence of shorts and the distance between adjacent terminals when the adhesive film of Example 1 was used.
Fig. 3 is a graph illustrating the relationship between the occurrence of shorts and the distance between adjacent terminals when the anisotropic conductive film of Comparative Example 4 was used.

### BEST MODE FOR CARRYING OUT THE INVENTION

The present invention is an adhesive film for flip-chip mounting a semiconductor chip having a bump on a wiring board. This adhesive film is formed into a film by dispersing a filler in a binder composition. Examples of wiring boards which may be employed include wiring boards widely used in semiconductor devices, such as a glass epoxy wiring board, a glass wiring board, and a flexible wiring board. Examples of semiconductor chips which may be employed include semiconductor chips widely used in semiconductor devices, such as an integrated circuit chip and a light-emitting diode chip. Furthermore, the binder composition includes a filler in addition to an epoxy compound and a curing agent which serve as film-forming components. The binder composition exhibits thermosetting properties.

The filler is mainly used to reduce the linear expansion coefficient and the water absorbing property of the adhesive film. The filler includes first non-conductive inorganic particles and conductive particles obtained by subjecting second non-conductive inorganic particles to an electroless plating treatment. Fillers used in known non-conductive adhesive films which are used during NCF bonding may be used as the first non-conductive inorganic particles and the second non-conductive inorganic particles. Preferred examples of the filler include silica fine particles, alumina particles, titanium dioxide particles and the like. Among these, silica fine particles are used, since a hard cured product can be obtained comparatively inexpensively. The first non-conductive inorganic particles and the second non-conductive inorganic particles may be the same or different. It should be noted that examples of the filler according to the present invention exclude conductive particles obtained by providing a metal layer by an electroless plating treatment on the surface of an organic resin core.

The average particle size of the first and second non-conductive inorganic particles is 0.5 to 1.0 µm, and preferably 0.5 to 0.8 µm each. This is because if the average particle size is less than 0.5 µm, during the mounting of the semiconductor, the contained large-particle-size filler breaks through a protective film protecting the semiconductor circuit face, thereby causing defects. In particular, for conductive particles, such a particle size becomes a factor in deterioration of the insulating properties. On the other hand, if the particle size is more than 1.0 µm, the insulating properties deteriorate. Here, the "average particle size" is a value measured by laser diffractometry.

The second non-conductive inorganic particles are subjected to a known electroless plating treatment to form an electroless plating layer on the surface thereof and used as conductive particles to which conductivity is imparted. This is to ensure continuity between the wiring board and the semiconductor chip, even if the filler and the binder composition are not sufficiently removed from between the connection pad or bump of the wiring board and the bump of the semiconductor chip. A conventional electroless plating layer formed on an anisotropic conductive particle may be used as the electroless plating layer. Examples thereof which may be preferably used include an electroless plating layer formed from gold, nickel, nickel/gold, or solder or the like. However, the electroless plating is conducted so that the average particle size of the conductive particles does not exceed 1.5 µm, and is preferably 1.1 µm or less. This is because if the average particle size exceeds 1.5 µm, it becomes more difficult to ensure the insulating state between adjacent terminals.

If the average particle size of the conductive particles is too small with respect to the average particle size of the first non-conductive inorganic particles, the effect of ensuring continuity between the semiconductor chip bump and an electrode on the board is decreased. Furthermore, if the average particle size is too large, the insulating properties between adjacent terminals deteriorate. Accordingly, the average particle size of the conductive particles is preferably 1.0 to 2.0 times, and more preferably 1.0 to 1.5 times, the average particle size of the first non-conductive inorganic particles.

The content ratio of the above-described conductive particles in the filler is 10 to 60 mass%, and preferably 30 to 50 mass%. This is because if the content ratio is less than 10 mass%, the initial continuity properties markedly deteriorate, and if the content ratio is more than 60 mass%, the insulating properties markedly deteriorate.

The amount of the filler formed from the first and second non-conductive inorganic particles and contained in the adhesive film of the present invention is 10 to 70 mass%, preferably 40 to 60 mass%, and more preferably 50 to 60 mass% with respect to the total amount of the epoxy compound, the curing agent and the filler, which corresponds to the total solid content of the binder composition. This is because if the amount of the filler is less than 10 mass%, the service life properties of the connected structure deteriorate, and if it is more than 70 mass%, film formation becomes difficult.

As described above, the binder composition forming the adhesive film of the present invention includes an epoxy compound and a curing agent therefor which serve as the film-forming components.

Preferred examples of the epoxy compound include compounds or resins having two or more epoxy groups in the molecule. These may be liquid or solid. More specifically, examples of epoxy compounds which may be used include difunctional epoxy resins such as bisphenol A epoxy resin, and bisphenol F epoxy resin, novolac epoxy resins such as phenol novolac epoxy resin and cresol novolac epoxy resin, and alicyclic epoxy compounds such as 3,4-epoxycyclohexenylmethyl-3',4'-epoxycyclohexen carboxylate.

In the binder composition, the epoxy compound may be used together with a compatible phenoxy resin or acrylic resin.

As the curing agent forming the adhesive film of the present invention, a curing agent for an epoxy compound which is used for conventional anisotropic conductive films may be used. Examples thereof include amine curing agents, imidazole curing agents, acid anhydride curing agents and the like. The curing agent may also be latent.

A known curing accelerator, coupling agent, metal scavenger and the like may optionally be added to the binder composition if required.

The adhesive film of the present invention can be produced according to an ordinary method. The adhesive film of the present invention can be produced by uniformly mixing the filler in the epoxy compound along with a solvent such as toluene or ethyl acetate, coating the resultant mixture on a release film to a predetermined dry film thickness, and then drying.

The adhesive film of the present invention can be preferably applied as an adhesive film for use in flip-chip mounting a semiconductor chip having a bump on a wiring board. Therefore, a connected structure which is formed with a semiconductor chip having a bump connected and fixed to a wiring board via the adhesive film of the present invention ensures reliable continuity due to the conductive particles, even if the binder resin is not sufficiently removed from between the connection pad or bump of the wiring board and the bump of the semiconductor chip. This connected structure can be produced by temporally sticking the adhesive film on the connection pad or bump of the wiring board, placing the semiconductor chip having a bump on the adhesive film so that the bump face is on the wiring board side, and then heating and pressing to connect and fix the semiconductor chip to the wiring board.

### EXAMPLES

The present invention will now be described in more detail with reference to the following examples.

The wiring board for evaluation used in the following examples or comparative examples is a glass epoxy circuit board having a size of 0.6 mm thick, 35 mm long, and 35 mm wide. On this wiring board, 12 µm-thick copper wiring, a surface of which has been plated with a nickel/gold plating, is formed. Furthermore, the semiconductor chip for evaluation is a silicon chip having a size 0.4 mm thick, 7.3 mm long, and 7.3 mm wide, on which was provided a gold stud bump (544 pins, 50 µm pitch).

### Reference Example 1 (Production of Conductive Particles with Non-Conductive Inorganic Particle Core)

An electroless nickel plating treatment was carried out using an electroless nickel plating bath on silica particles having an average particle size of 0.5 µm (spherical silica, Tokuyama Corp.). The particles obtained by the electroless nickel plating treatment were further subjected to an electroless gold plating treatment using an electroless gold plating bath, to obtain conductive particles having an average particle size of 0.6 µm.

### Reference Example 2 (Production of Conductive Particles with Non-Conductive Inorganic Particle Core)

Conductive particles having an average particle size of 1.1 µm were obtained in the same manner as in Reference Example 1, except that silica fine particles having an average particle size of 1.0 µm (spherical silica, Tokuyama Corp.) were used instead of the silica particles having an average particle size of 0.5 µm.

### Reference Example 3 (Production of Conductive Particles with Non-Conductive Inorganic Particle Core)

Conductive particles having an average particle size of 3.6 µm were obtained in the same manner as in Reference Example 1, except that silica fine particles having an average particle size of 3.5 µm (Hipresica, Ube-Nitto Kasei Co., Ltd.) were used instead of the silica particles having an average particle size of 0.5 um.

### Comparative Example 1 (Production of Adhesive Film)

A mixture of 50 parts by mass of epoxy resin (Epicoat 828, Japan Epoxy Resins Co., Ltd.), 100 parts by mass of a latent curing agent (HX3941HP, Asahi Kasei Chemicals Corporation), and 50 parts by mass of silica fine particles having an average particle size of 0.5 µm (spherical silica, Tokuyama Corp.) was dissolved and dispersed in toluene to form a thermosetting adhesive composition with a solid content of 50 mass%. This thermosetting adhesive composition was applied to a polyethylene terephthalate (PET) film which had undergone a peeling treatment and had a thickness of 50 µm (Separator, Tohcello Co., Ltd.) so that the resultant product would have a dry thickness of 40 µm. The coated composition was then dried at 80°C to produce the thermosetting adhesive film of Comparative Example 1.

### Example 1

A mixture of 50 parts by mass of epoxy resin (Epicoat 828, Japan Epoxy Resins Co., Ltd.), 100 parts by mass of a latent curing agent (HX3941HP, Asahi Kasei Chemicals Corporation), 45 parts by mass of silica fine particles having an average particle size of 0.5 µm (spherical silica, Tokuyama Corp.), and 5 parts by mass of the conductive particles of Reference Example 1 was dissolved and dispersed in toluene to form a thermosetting adhesive composition with a solid content of 50 mass%. This thermosetting adhesive composition was applied to a PET film which had undergone a peeling treatment and had a thickness of 50 µm (Separator, Tohcello Co., Ltd.) so that the resultant product would have a dry thickness of 40 µm. The coated composition was then dried at 80°C to produce the thermosetting adhesive film of Example 1. The amount of the filler contained with respect to the total solid amount (total of the epoxy resin, the curing agent, and the filler) was 25 mass%.

### Example 2

The thermosetting adhesive film of Example 2 was produced in the same manner as in Example 1, except that the 45 parts by mass of silica fine particles having an average particle size of 0.5 µm was changed to 25 parts by mass, and the amount of conductive particles was changed to 25 parts by mass.

### Comparative Example 2

The thermosetting adhesive film of Comparative Example 2 was produced in the same manner as in Example 1, except that the 45 parts by mass of silica fine particles having an average particle size of 0.5 µm was changed to 5 parts by mass, and the 5 parts by mass of the conductive particles of Reference Example 1 was changed to 45 parts by mass.

### Example 3

The thermosetting adhesive film of Example 3 was produced in the same manner as in Example 1, except that the 45 parts by mass of silica fine particles having an average particle size of 0.5 µm was changed to 25 parts by mass, and 25 parts by mass of the conductive particles of Reference Example 2 was used instead of the 5 parts by mass of the conductive particles of Reference Example 1.

### Comparative Example 3

The thermosetting adhesive film of Comparative Example 3 was produced in the same manner as in Example 3, except that silica particles having an average particle size of 3.5 µm (Hipresica, Ube-Nitto Kasei Co., Ltd.) were used instead of the silica fine particles having an average particle size of 0.5 µm, and the conductive particles of Reference Example 3 were used instead of the conductive particles of Reference Example 2.

### Comparative Example 4

The thermosetting anisotropic conductive film of Comparative Example 4 was produced in the same manner as in Example 1, except that the silica fine particles having an average particle size of 0.5 µm were not used, and 10 parts by mass of conductive particles having an average particle size of 4.0 µm (Bright, Nippon Chemical Industrial Co., Ltd.) obtained by electroless plating of the surface of an organic particle core with nickel and gold was used instead of the 5 parts by mass of the conductive particles of Reference Example 1.

### Comparative Example 5

The thermosetting anisotropic conductive film of Comparative Example 5 was produced in the same manner as in Example 1, except that conductive particles having an average particle size of 4.0 µm (Bright, Nippon Chemical Industrial Co., Ltd.) obtained by electroless plating of the surface of an organic particle core with nickel and gold were used instead of the conductive particles of Reference Example 1.

### Example 4

The thermosetting anisotropic conductive film of Example 4 was produced in the same manner as in Example 1, except that the amount of silica fine particles was changed from 45 parts by mass to 75 parts by mass, and the amount of conductive particles was changed from 5 parts by mass to 75 parts by mass. In the present example, the amount of the filler contained with respect to the total amount of the epoxy compound, the curing agent, and the filler, which corresponds to the total solid amount of the binder composition, was 50 mass%.

### Example 5

The thermosetting anisotropic conductive film of Example 5 was produced in the same manner as in Example 1, except that the amount of silica fine particles was changed from 45 parts by mass to 175 parts by mass, and the amount of conductive particles was changed from 5 parts by mass to 175 parts by mass. In the present example, the amount of the filler contained with respect to the total amount of the epoxy compound, the curing agent, and the filler, which corresponds to the total solid amount of the binder composition, was 70 mass%.

### (Evaluation 1)

Each of the adhesive films and the anisotropic conductive films of the examples and comparative examples was temporally stuck on an electrode pad of the wiring board for evaluation. The release film was removed, and then the semiconductor chip for evaluation was mounted from its bump face thereon. The semiconductor chip was heated and pressed at a temperature of 180°C and a pressure of 2.5 MPa for 20 seconds to produce a connected structure sample for conductive resistance measurement.

The initial conductive resistance (Ω) (daisy chain resistance (136 electrode connection resistance + wire resistance)) and the insulation resistance (Ω) (daisy chain inter-wire insulation resistance (Ω) (136 interelectrode minimum value, less than 10⁸ Ω determined as a short)) were measured for the obtained connected structure samples. Next, as a reliability test, a PCT test (conditions: left for 24 hours at 121°C in a saturated water vapor pressure chamber) was carried out on the samples to measure the conductive resistance. As an overall evaluation, cases where opens or shorts did not occur were evaluated as "good", and cases where at least either of these occurred were evaluated as "poor". The obtained results are shown in Table 1.

**[Table 1]**

| | | | Comparative Example 1 | Example 1 | Example 2 | Comparative Example 2 | Example 3 | Comparative Example 3 | Comparative Example 4 | Comparative Example 5 | Example 4 | Example 5 |
|---|---|---|---|---|---|---|---|---|---|---|---|---|
| Epoxy Resin + Curing Agent | | Parts by mass | 150 | 150 | 150 | 150 | 150 | 150 | 150 | 150 | 150 | 150 |
| Filler | Silica Fine Particles | Average particle size (µm) | 0.5 | 0.5 | 0.5 | 0.5 | 0.5 | 3.5 | - | 0.5 | 0.5 | 0.5 |
| | | Parts by mass | 50 | 45 | 25 | 5 | 25 | 25 | 0 | 45 | 75 | 175 |
| | Conductive Partides with Silica Fine Partide Core | Average particle size(µm) | - | 0.6 | 0.6 | 0.6 | 1.1 | 3.6 | - | - | 0.6 | 0.6 |
| | | Parts by mass | 0 | 5 | 25 | 45 | 25 | 25 | 0 | 0 | 75 | 175 |
| Amount of Filler in Solid | | mass% | 25 | 25 | 25 | 25 | 25 | 25 | 0 | 23 | 50 | 70 |
| Conductive Particles with Organic Particle Core | | Average particle size (µm) | - | - | - | - | - | - | 4 | 4 | - | - |
| | | Parts by mass | 0 | 0 | 0 | 0 | 0 | 0 | 10 | 5 | 0 | 0 |
| Initial Properties | | Conductive Resistance (Ω) | Open | 60 | 60 | 60 | 60 | 60 | 60 | Open | 60 | 60 |
| | | Insulation Resistance (Ω) | 10¹⁰ | 10¹⁰ | 10¹⁰ | Short/10³ | 10¹⁰ | Short/10⁶ | 10⁹ | 10¹⁰ | 10¹⁰ | 10¹⁰ |
| Reliability | | Conductive Resistance (Ω) | Open | 67 | 65 | 67 | 62 | Open | Open | Open | 62 | 62 |
| Overall Evaluation | | | Poor | Good | Good | Poor | Good | Poor | Poor | Poor | Good | Good |

As shown in Table 1, the adhesive films of Examples 1 to 5, in which silica fine particles and conductive particles obtained by subjecting those silica fine particles to an electroless plating treatment were used, exhibited good results for the evaluation items.

On the other hand, for the adhesive film of Comparative Example 1, which contained no conductive particles at all, the connected structure sample was open in the initial conductive resistance measurement. For the adhesive film of Comparative Example 2, the added amount of conductive particles was too much, and thus a short occurred between adjacent electrodes. For the adhesive film of Comparative Example 3, the size of the conductive particles was too large, which decreased the number of conductive particles per unit surface area. As a result, the conductive particles were not always trapped between the electrodes, so that an open occurred in the daisy chain resistance measurement. Furthermore, when the space between the electrodes was small, a short also occurred.

For the adhesive film of Comparative Example 4, in which silica fine particles were not used and conventional organic resin core-type conductive particles were used, although the initial properties were good, the conductive resistance after the PCT test was open, which meant that the reliability was poor. Furthermore, for the adhesive film of Comparative Example 5, in which silica fine particles were used in addition to organic resin core-type conductive particles, the initial conductive resistance was open.

### (Evaluation 2)

The relative permittivity and the insulating properties of the adhesive film of Example 1 and the anisotropic conductive film of Comparative Example 4 were evaluated as follows.

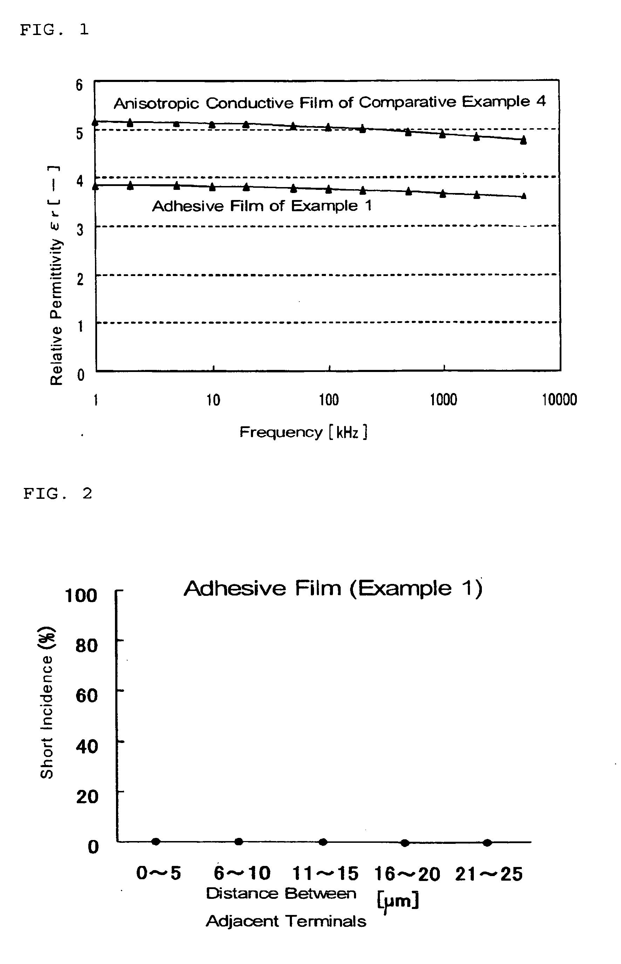

The relative permittivity was measured using a relative permittivity measurement apparatus (LF Impedance Analyzer 4192A, Hewlett-Packard; using electrode 16451B for permittivity measurement (electrode A, diameter 38 mm); frequency 1, 2, 5, 10, 20, 50, 100, 200, 500, 1000, 2000, and 5000 (kHz); voltage 1 V). The higher insulating properties, the lower the relative permittivity. The obtained results are shown in Fig. 1. It can be seen from Fig. 1 that the adhesive film of Example 1 has higher insulating properties than the anisotropic conductive film of Comparative Example 4.

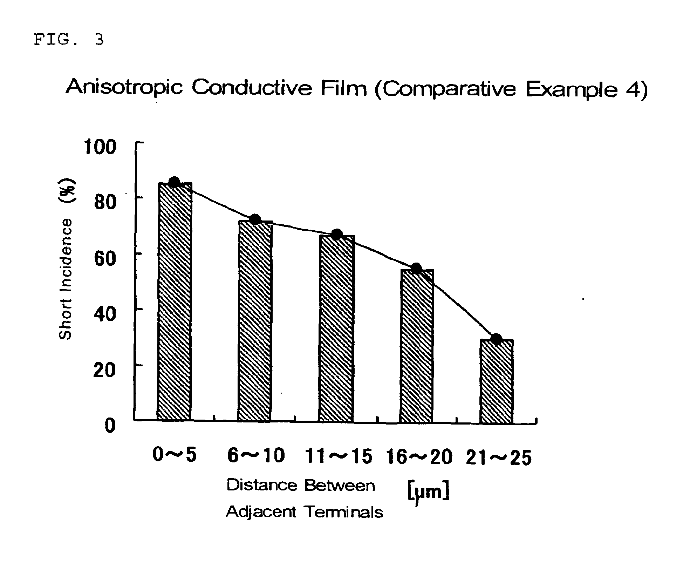

For the insulating properties, a semiconductor chip (bump size: 50 x 150 µm, pitch: 80 µm pitch) was flip-chip mounted on an ITO pad, and the relationship between the occurrence of shorts (insulation resistance of 10⁸ Ω or less) and the distance between adjacent terminals was investigated. The obtained results are shown in Figs. 2 and 3. From Figs. 2 and 3, it can be seen that although the adhesive film of Example 1 had no shorts at all, the anisotropic conductive film of Comparative Example 4 had a marked occurrence of shorts.

### INDUSTRIAL APPLICABILITY

According to the method for producing a semiconductor device of the present invention, the mounting of the semiconductor chip on the circuit board and the sealing of the semiconductor chip are carried out simultaneously by a single thermocompression bonding treatment using a sealing resin film having a thermosetting sealing resin layer with a predetermined thickness. Consequently, a connection portion formed between the circuit board and the semiconductor chip is not again affected by the application of heat and pressure after connection. Therefore, the number of steps can be reduced and the yield can be improved. Thus, the present invention is useful as a method for producing a semiconductor device.

## Claims

1. An adhesive film comprising a binder composition including an epoxy compound, a curing agent, and a filler, for flip-chip mounting a semiconductor chip having a bump on a wiring board, wherein
an amount of the filler is 10 to 70 mass% with respect to a total amount of the epoxy compound, the curing agent, and the filler,
the filler includes a first non-conductive inorganic particle having an average particle size of 0.5 to 1.0 µm, and a conductive particle formed by subjecting a second non-conductive inorganic particle having an average particle size of 0.5 to 1.0 µm to an electroless plating treatment so that an average particle size of the conductive particle does not exceed 1.5 µm, and
the conductive particle is contained in an amount of 10 to 60 mass% of the filler.

2. The adhesive film according to claim 1, wherein the first and second non-conductive inorganic particles are any of a silica fine particle, an alumina particle and a titanium dioxide particle.

3. The adhesive film according to claim 1 or 2, wherein the average particle size of the first and second non-conductive inorganic particles is 0.5 to 0.8 µm.

4. The adhesive film according to any of claims 1 to 3, wherein the particle size of the conductive particle is 1.1 µm or less.

5. The adhesive film according to any of claims 1 to 4, wherein the average particle size of the conductive particle is 1.0 to 2.0 times the average particle size of the first non-conductive inorganic particle.

6. The adhesive film according to any of claims 1 to 5, wherein a metal type for use in the electroless plating treatment is any of gold, nickel, nickel/gold, and solder.

7. A connected structure formed with a semiconductor chip having a bump connected and fixed to a wiring board via the adhesive film according to any of claims 1 to 6.

8. The connected structure according to claim 7, wherein the bump of the semiconductor chip and a bump of the wiring board are connected to each other.

## Patentansprüche

1. Haftmittelfolie, umfassend eine Bindemittelzusammensetzung, einschließend eine Epoxyverbindung, ein Härtungsmittel und einen Füllstoff, für die Flip-Chip Montage eines Halbleiterchips, der einen Kontakthöcker auf einer Leiterplatte aufweist, wobei
eine Menge des Füllstoffs von 10 bis 70 Massen% bezüglich einer Gesamtmenge der Epoxyverbindung, des Härtungsmittels und des Füllstoffs beträgt,
der Füllstoff ein erstes nichtleitendes anorganisches Teilchen, aufweisend einen durchschnittlichen Teilchendurchmesser von 0,5 bis 1,0 µm, und ein leitendes Teilchen, gebildet durch Unterziehen eines zweiten nichtleitenden anorganischen Teilchens, aufweisend eine durchschnittliche Teilchengröße von 0,5 bis 1,0 µm einer stromlosen Platierungsbehandlung, so dass eine durchschnittliche Teilchengröße des leitenden Teilchens nicht 1,5 µm überschreitet, einschließt, und
das leitende Teilchen in einer Menge von 10 bis 60 Massen% des Füllstoffes enthalten ist.

2. Haftmittelfolie nach Anspruch 1, wobei die ersten und zweiten nichtleitenden anorganischen Teilchen irgendeines von einem Siliziumdioxidfeinteilchen, einem Aluminiumoxidteilchen und einem Titandioxidteilchen sind.

3. Haftmittelfolie nach Anspruch 1 oder 2, wobei die durchschnittliche Teilchengröße der ersten und zweiten anorganischen Teilchen von 0,5 bis 0,8 µm beträgt.

4. Haftmittelfolie nach einem der Ansprüche 1 bis 3, wobei die Teilchengröße des leitenden Teilchens 1,1 µm oder weniger beträgt.

5. Haftmittelfolie nach einem der Ansprüche 1 bis 4, wobei die durchschnittliche Teilchengröße des leitenden Teilchens das 1,0 bis 2,0-fache der durchschnittlichen Teilchengröße des ersten nichtleitenden anorganischen Teilchens beträgt.

6. Haftmittelfolie nach einem der Ansprüche 1 bis 5, wobei eine Metallart für die Verwendung in der stromlosen Platierungsbehandlung irgendeines von Gold, Nickel, Nickel/Gold und Lötmetall ist.

7. Verbundene Struktur, gebildet aus einem Halbleiterchip mit einem Kontakthökker, verbunden und befestigt an einer Leiterplatte über die Haftmittelfolie nach einem der Ansprüche 1 bis 6.

8. Verbunde Struktur nach Anspruch 7, wobei der Kontakthöcker des Halbleiterchips und ein Kontakthöcker der Leiterplatte miteinander verbunden sind.

## Revendications

1. Film adhésif comprenant une composition liante contenant un composé époxy, un agent de durcissement, et une charge, pour le montage en puce retournée d'une puce semi-conductrice ayant un contact surélevé sur une carte électronique, où
la quantité de charge se situe dans l'intervalle allant de 10 à 70% en masse par rapport à la quantité totale du composé époxy de l'agent de durcissement et de la charge,
la charge comprend des premières particules inorganiques non conductrices présentant une taille moyenne des particules allant de 0,5 à 1,0 µm, et des particules conductrices formées en soumettant des deuxièmes particules inorganiques non conductrices présentant une taille moyenne des particules allant de 0,5 à 1,0 µm à un traitement de dépôt sans courant de sorte que la taille moyenne des particules conductrices ne dépasse pas 1,5 µm, et
les particules conductrices sont présentes en une quantité allant de 10 à 60% en masse de la charge.

2. Film adhésif selon la revendication 1, où les premières et deuxièmes particules inorganiques non conductrices sont l'une quelconque parmi de fines particules de silice, des particules d'alumine et des particules de dioxyde de titane.

3. Film adhésif selon la revendication 1 ou 2, où la taille moyenne des particules des premières et deuxièmes particules inorganiques non conductrices se situe dans l'intervalle allant de 0,5 à 0,8 µm.

4. Film adhésif selon l'une quelconque des revendications 1 à 3, où la taille moyenne des particules conductrices est de 1,1 µm ou moins.

5. Film adhésif selon l'une quelconque des revendications 1 à 4, où la taille moyenne des particules conductrices est de 1,0 à 2,0 fois la taille moyenne des particules des premières particules inorganiques non conductrices.

6. Film adhésif selon l'une quelconque des revendications 1 à 5, où le métal à utiliser dans le traitement de dépôt sans courant est l'un quelconque parmi l'or, le nickel, le nickel/or, et la soudure.

7. Structure connectée formée d'une puce semi-conductrice ayant un contact surélevé connecté et fixé à une carte électronique via le film adhésif selon l'une quelconque des revendications 1 à 6.

8. Structure connectée selon la revendication 7, où le contact surélevé de la puce semi-conductrice et un contact surélevé de la carte électronique sont connectés l'un à l'autre.
